Europäisches Patentamt

European Patent Office

Office européen des brevets

(11) Veröffentlichungsnummer: **0 075 892**
**A2**

(12) **EUROPÄISCHE PATENTANMELDUNG**

(21) Anmeldenummer: 82108853.1

(22) Anmeldetag: 24.09.82

(51) Int. Cl.³: **H 01 L 23/56**
H 01 L 21/314, H 01 L 21/285
H 01 L 23/28

(30) Priorität: 25.09.81 DE 3138324

(43) Veröffentlichungstag der Anmeldung:
06.04.83 Patentblatt 83/14

(84) Benannte Vertragsstaaten:
AT DE FR GB IT

(71) Anmelder: SIEMENS AKTIENGESELLSCHAFT
Berlin und München Wittelsbacherplatz 2
D-8000 München 2(DE)

(72) Erfinder: Roloff, Herbert F., Dr.rer.nat.
Akademiestrasse 21
D-8000 München 40(DE)

(72) Erfinder: Mitlehner, Heinz, Dr.rer.nat.
Hohenzollernstrasse 104
D-8000 München 40(DE)

(54) Integrierter Halbleiterschaltkreis mit einer halbisolierenden Halbleiterschicht.

(57) Integrierter Halbleiterschaltkreis mit einer halbisolierenden Schicht (8) aus amorphem Silicium auf einem die
Funktionseinheiten (beispielsweise 2', 4, 5, 6) des Schaltkreises enthaltenden einkristallinen Halbleiter-Körper (1, 2) zur
Erhöhung der elektrischen Spannungsfestigkeit und mit
einer auf der halbisolierenden Halbleiterschicht (8) vergesehenen Isolationsschicht (9).

EP 0 075 892 A2

Croydon Printing Company Ltd.

0075892

SIEMENS AKTIENGESELLSCHAFT     Unser Zeichen
Berlin und München     VPA

81 P 1 1 4 9 . E

BEZEICHNUNG GEÄNDERT
siehe Innenseite

## Integrierter Halbleiterschaltkreis

Die vorliegende Erfindung betrifft einen integrierten Halbleiterschaltkreis mit einer halbisolierenden Halbleiterschicht auf einem die Funktionseinheiten des Schaltkreises enthaltenden einkristallinen Halbleiterkörper zur Erhöhung der elektrischen Spannungsfestigkeit und elektrischen Abschirmung und mit einer auf der halbisolierenden Halbleiterschicht vorgesehenen Isolationsschicht.

Aus der Zeitschrift "IEEE Transactions on Electron Devices", Vol. ED-23, Nr. 8, Augugst 1976, S. 826-830 ist es bekannt, daß Hochspannungstransistoren eine große Spannungsfestigkeit und damit eine große Zuverlässigkeit besitzen, wenn zu ihrer Oberflächenpassivierung halbisolierende polykristalline Siliciumschichten verwendet werden. Dabei handelt es sich um chemisch aus der Gasphase abgeschiedene, mit Sauerstoff oder Stickstoffatomen dotierte polykristalline Siliciumschichten. Auf derartigen polykristallinen Siliciumschichten können Siliciumoxid-Schichten aufgebracht werden, um im Hochspannungsbetrieb einen dielektrischen Durchbruch zu verhindern.

Derartige polykristalline Siliciumschichten besitzen jedoch noch den Nachteil, daß aufgrund des polykristallinen Zustandes leitende Kristallite mit Korngrenzen-Effekten vorhanden sind, woraus ein schlecht reproduzierbarer elektrischer Widerstand resultiert. Weiterhin sind derartige polykristalline Schichten nicht ausreichend dicht, um das Eindringen von Feuchtigkeit bis zur Oberfläche des einkristallinen Halbleiterkörpers, auf dem die polykristalli-

Lz 1 Kth    / 25.9.1981

ne Siliciumschicht aufgebracht ist, zu vermeiden. Zwar wird gemäß einem Vorschlag der vorgenannten Druckschrift eine Dotierung mit Stickstoff zum Zwecke der Herabsetzung der Feuchteempfindlichkeit in Betracht gezogen. Dies ist jedoch relativ aufwendig, da neben der Dotierung mit Sauerstoff zur Festlegung des elektrischen Widerstandes der polykristallinen Siliciumschicht ein weiterer Dotierungsschritt zur Herabsetzung der Feuchteempfindlichkeit erforderlich ist.

Der vorliegenden Erfindung liegt die Aufgabe zugrunde, eine verbesserte Möglichkeit zur Erhöhung der elektrischen Spannungsfestigkeit von integrierten Halbleiterschaltkreisen anzugeben.

Dieser Aufgabe wird bei einem integrierten Halbleiterschaltkreis der eingangs genannten Art erfindungsgemäß dadurch gelöst, daß die halbisolierende Halbleiterschicht eine Schicht aus amorphem Halbleitermaterial ist.

In Weiterbildung der Erfindung ist bei einem Verfahren zur Herstellung eines integrierten Halbleiterschaltkreises, bei dem nach den Dotierungsprozessen zur Herstellung der Funktionseinheiten von der Oberfläche des Halbleiterkörpers das dabei ausgenutzte Oxid ganzflächig entfernt wird, vorgesehen, daß auf den die Funktionseinheiten enthaltenden Halbleiterkörper eine Schicht aus amorphem Halbleitermaterial aufgebracht und diese Schicht sodann getempert wird.

Weitere Ausgestaltungen des Erfindungsgedankens sowohl hinsichtlich des vorstehend definierten integrierten Halbleiterschaltkreises als auch hinsichtlich des Verfahrens zu seiner Herstellung sind in entsprechenden Unteransprüchen gekennzeichnet.

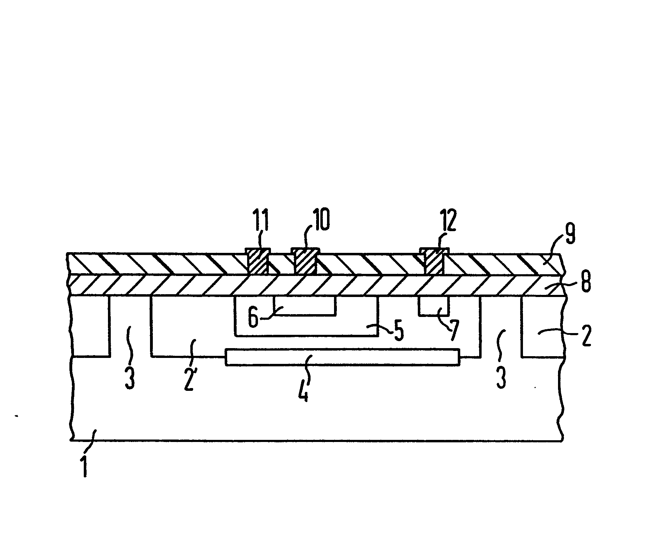

Die Erfindung wird im folgenden anhand eines in der einzigen Figur der Zeichnung dargestellten Ausführungsbeispiels näher erläutert.

Die Figur der Zeichnung zeigt eine schematische Darstellung eines Teils eines integrierten bipolaren Halbleiterschaltkreises mit einem Transistor als Funktionseinheit dieses Schaltkreises.

Ein in der Figur der Zeichnung schematisch dargestellter integrierter Halbleiterschaltkreis besitzt in konventioneller Weise ein Substrat 1 aus einkristallinem Halbleitermaterial, insbesondere Silicium des einen Leitungstyps, auf das eine Schicht 2 des anderen Leitungstyps epitaktisch abgeschieden ist. Durch übliche Isolationsdiffusionen 3 mit dem Leitungstyp des Substrates 1 wird eine isolierte Wanne 2' gebildet, die zur Aufnahme einer Funktionseinheit, hier eines Transistors des integrierten Halbleiterschaltkreises dient. Der Transistor wird dabei durch einen Buried-Layer 4, die isolierte Wannenzone 2' als Kollektor, eine Zone 5 als Basis und eine Zone 6 als Emitter gebildet. Eine hochdotierte Zone 7 dient als Kollektor-Anschlußzone.

Auf der Oberfläche des vorstehend beschriebenen integrierten Halbleiterschaltkreises ist nun erfindungsgemäß eine Halbleiterschicht 8 aus amorphem Halbleitermaterial, insbesondere aus amorphem Silicium zur Erhöhung der elektrischen Spannungsfestigkeit und der elektrischen Abschirmung des integrierten Halbleiterschaltkreises vorgesehen. Die amorphen Halbleiterschichten werden vorzugsweise durch Elektronenstrahlverdampfung oder Spattern aufgebracht. Diese Schicht aus amorphem Halbleitermaterial besitzt vorzugsweise einen Sauerstoffgehalt unter 10 %, eine elektrische Leitfähigkeit in der Größenordnung von vorzugsweise $10^7$

bis $10^8$   und eine Dicke in der Größenordnung von 10 bis 500 nm, vorzugsweise 50 nm.

Auf der Schicht 8 aus amorphem Halbleitermaterial ist eine Isolationsschicht, beispielsweise eine Siliciumnitrid-Schicht 9 vorgesehen, durch die hindurch die Funktionseinheiten im integrierten Schaltkreis direkt über die Schicht 8 aus amorphem Halbleitermaterial kontaktiert werden. In der Figur in der Zeichnung ist zur Kontaktierung des Transistors ein Emitterkontakt 10, ein Basiskontakt 11 sowie ein Kollektorkontakt 12 schematisch dargestellt.

Ein integrierter Halbleiterschaltkreis der vorstehend beschriebenen Art wird erfindungsgemäß zweckmäßigerweise folgendermaßen hergestellt.

Nach Abschluß der Diffusion für den Emitter 6 wird das dabei auf der Oberfläche des Halbleiterkörpers 1, 2 ausgenutzte Oxid ganzflächig entfernt und sodann die amorphe Siliciumschicht 8 vorzugsweise durch Aufdampfen oder Sputtern bei einer Temperatur des Halbleiterkörpers 1,2 von 100 bis bis $350^{\circ}$C, insbesondere $200^{\circ}$C, aufgebracht. Anschließend wird diese Schicht 8 vorzugsweise bei einer Temperatur in der Größenordnung von 250 bis $500^{\circ}$C getempert. Sodann wird die Isolationsschicht 9, beispielsweise in Form von Siliciumoxid oder Siliciumnitrid nach bekannten Verfahren bei Temperaturen unter $500^{\circ}$C abgeschieden. Die weiteren Prozesse der Herstellung, beispielsweise die Herstellung der Kontaktelektroden 10, 11 und 12 entsprechen den konventionellen Techniken für die Herstellung integrierter Halbleiterschaltkreise.

Das vollständig beschriebene Verfahren ist generell für alle bipolaren integrierten Schaltkreise, insbesondere für npn-Transistoren sowie laterale und vertikale pnp-Transistoren geeignet. Darüberhinaus ist das Verfahren auch für MOS-Schaltkreise geeignet, wobei jedoch das Gate-Oxid von MOS-Transistoren bei der Oxidabätzung mit Hilfe einer Fototechnik stehen bleiben muß.

Erfindungsgemäß ausgebildete integrierte Halbleiterschaltkreise sowie das Verfahren zu ihrer Herstellung ergeben insbesondere folgende Vorteile.

Parasitäre MOS-Kanäle, welche beispielsweise durch über die Isolationsschicht 9 verlaufende Leiterbahnen (nicht dargestellt) gebildet werden, besitzen eine sehr hohe Einsatzspannung von 300 V. Weiterhin ergeben sich stabile hohe Sperrspannungen. Dadurch ist die Herstellung zuverlässiger hochsperrender integrierter Schaltkreise möglich, wobei der aktive Bauelementbereich gegenüber Einflüssen von Deckschichten vollständig abgeschirmt wird.

1 Figur
10 Patentansprüche

<u>Patentansprüche</u>

1. Integrierter Halbleiterschaltkreis mit einer halbisolierenden Halbleiterschicht auf einem die Funktionseinheiten des Schaltkreises enthaltenden einkristallinen Halbleiterkörpers zur Erhöhung der elektrischen Spannungsfestigkeit und elektrischen Abschirmung und mit einer auf der halbisolierenden Halbleiterschicht vorgesehenen Isolationsschicht, d a d u r c h g e k e n n - z e i c h n e t, daß die halbisolierende Halbleiterschicht (8) eine Schicht aus amorphem Halbleitermaterial ist.

2. Integrierter Halbleiterschaltkreis nach Anspruch 1, d a d u r c h g e k e n n z e i c h n e t, daß das Halbleitermaterial für die halbisolierende Schicht (8) Silicium ist.

3. Integrierter Halbleiterschaltkreis nach Anspruch 1 und/oder 2, d a d u r c h g e k e n n z e i c h n e t, daß der Sauerstoff-Gehalt der Halbleiterschicht (8) unter 10 % liegt.

4. Integrierter Halbleiterschaltkreis nach einem der Ansprüche 1 bis 3, d a d u r c h g e k e n n z e i c h - n e t, daß die elektrische Leitfähigkeit der halbisolierenden Halbleiterschicht (8) in der Größenordnung von $10^7$ bis $10^8$ liegt.

5. Integrierter Halbleiterschaltkreis nach einem der Ansprüche 1 bis 4, d a d u r c h g e k e n n z e i c h - n e t, daß die Dicke der halbisolierenden Halbleiterschicht (8) in der Größenordnung von 10 bis 500 nm liegt.

**0075892**

6. Integrierter Halbleiterschaltkreis nach einem der Ansprüche 1·bis 5, d a d u r c h  g e k e n n z e i c h n e t, daß die Dicke der halbisolierenden Halbleiterschicht (8) gleich 50 nm ist.

7. Verfahren zur Herstellung eines integrierten Halbleiterschaltkreises nach einem der Ansprüche 1 bis 6, bei dem nach den Dotierungsprozessen zur Herstellung der Funktionseinheiten von der Oberfläche des Halbleiterkörpers das dabei ausgenutzte Oxid ganzflächig entfernt wird, d a d u r c h  g e k e n n z e i c h n e t, daß auf dem die Funktionseinheiten (beispielsweise 2', 4, 5, 6) enthaltenden Halbleiterkörper (1, 2) eine Schicht (8) aus amorphem Halbleitermaterial aufgebracht und diese Schicht (8) sodann getempert wird.

8. Verfahren nach Anspruch 7, d a d u r c h  g e k e n n z e i c h n e t, daß die Schicht (8) durch Aufdampfen oder Sputtern bei einer Temperatur des Halbleiterkörpers (1, 2) von 100 bis 350°C, insbesondere 200°C, aufgebracht wird.

9. Verfahren nach Anspruch 7 und/oder 8, d a d u r c h  g e k e n n z e i c h n e t, daß die Temperung bei einer Temperatur von 250 bis 500°C durchgeführt wird.

10. Verfahren nach einem der Ansprüche 7 bis 9, d a d u r c h  g e k e n n z e i c h n e t, daß auf der Schicht (8) aus amorphem Halbleitermaterial eine Isolationsschicht (9) vorzugsweise eine Siliciumnitrid-Schicht, bei einer Temperatur unterhalb 500°C abgeschieden wird.